Europäisches Patentamt

European Patent Office

Office européen des brevets

(19)

(11) EP 0 422 525 B1

(12) EUROPEAN PATENT SPECIFICATION

(45) Date of publication and mention
of the grant of the patent:
**31.01.1996 Bulletin 1996/05**

(51) Int Cl.⁶: **H01J 9/14**, G03F 9/00

(21) Application number: **90119165.0**

(22) Date of filing: **05.10.1990**

(54) **Exposing method and apparatus**

Verfahren und Vorrichtung zur Belichtung

Méthode et appareil pour exposition

(84) Designated Contracting States:
**DE FR GB**

(30) Priority: **07.10.1989 JP 262800/89**
**09.05.1990 JP 119334/90**

(43) Date of publication of application:
**17.04.1991 Bulletin 1991/16**

(73) Proprietor: **KABUSHIKI KAISHA TOSHIBA**
**Kawasaki-shi, Kanagawa-ken 210, Tokyo (JP)**

(72) Inventors:
• **Miyata, Yukitaka, c/o Intellectual Property Div.**
**Minato-ku, Tokyo 105 (JP)**
• **Asaka, Tatsuhiko, c/o Intellectual Property Div.**
**Minato-ku, Tokyo 105 (JP)**
• **Iijima, Hisashi, c/o Intellectual Property Div.**
**Minato-ku, Tokyo 105 (JP)**
• **Suwa, Shigeru, c/o Intellectual Property Div.**
**Minato-ku, Tokyo 105 (JP)**

(74) Representative: **Henkel, Feiler, Hänzel & Partner**
**D-81675 München (DE)**

(56) References cited:
FR-A- 2 360 686          US-A- 4 448 522
US-A- 4 656 107

• **PATENT ABSTRACTS OF JAPAN vol. 12, no. 71**
**(P-673)(2918) March 5, 1988 & JP-A-62-211 657**
• **PATENT ABSTRACTS OF JAPAN vol. 13, no.**
**114 (E-730)(3462) March 20, 1989 & JP-A-63-285**
**842**

## Description

The present invention relates to an exposing method and apparatus and more particularly, it relates to an exposing method and apparatus used in the course of manufacturing shadow masks for color picture tubes.

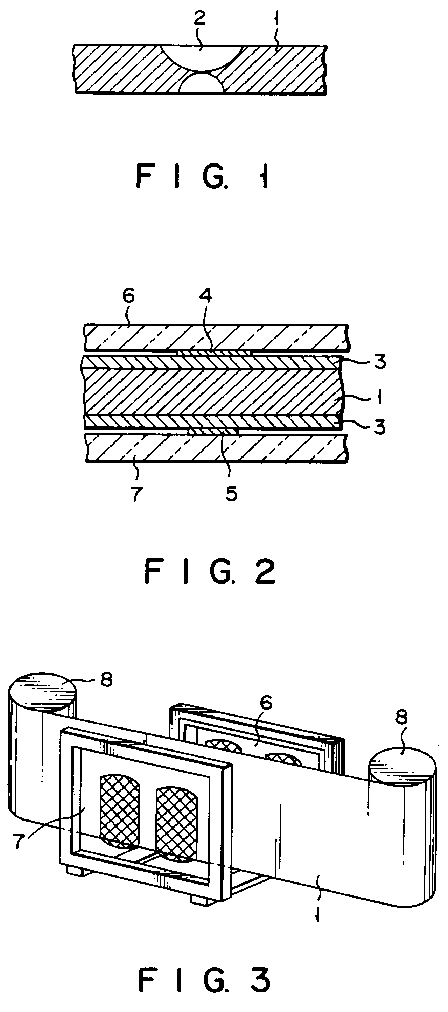

It is needed in the course of manufacturing shadow masks for color picture tubes that an iron plate 1 is selectively etched by acid on both sides thereof to accurately form a plurality of apertures 2 which pass through the iron plate 1, as shown in Fig. 1.

These apertures 2 are formed as follows. As shown in Fig. 2, photosensitive material is coated on both sides of the iron plate 1, which is then closely held between a first glass mask plate 6 on the inner side of which a large aperture pattern 4 is drawn and a second glass mask plate 7 on the inner side of which small aperture pattern 5 is drawn. Both sides of the iron plate 1 are irradiated by ultraviolet rays shot from a mercury-vapor lamp through the glass mask plates 6 and 7 to expose the photosensitive material on both sides of the iron plate 1. The photosensitive material on both sides of the iron plate 1 is developed, that is, that portion of the photosensitive material which is not exposed is removed from both sides of the iron plate 1 to form etching resistive patterns thereon. Using these etching resistive patterns as masks, the iron plate 1 is etched by acid to form a plurality of apertures 2 which pass through the iron plate 1.

When the large aperture pattern 4 is shifted from the small aperture pattern 5 upon the exposing step in the above-described process, the apertures, which are formed by etching the iron plate 1 with acid using the aperture patterns 4, 5 as etching masks, cannot have their predetermined shapes and sizes, or they cannot be passed through the iron plate 1 in the worst case.

In order to prevent this, the two glass mask plates 6 and 7 were opposed to each other without interposing the iron plate 1 between them to find by eyes whether or not they were aligned with each other. When they were not aligned with each other, one of them was moved to become aligned with the other.

However, this method of aligning the glass mask plates 6 and 7 with each other had the following problems.

In the case of the exposing apparatus used to make shadow masks for color picture tubes, the long iron plate 1 wound round drums 8 and fed, as shown in Figs. 3 and 4, is repeatedly exposed in the manner as shown in a flow chart in Fig. 5. When the iron plate 1 is once interposed between the glass mask plates 6 and 7, therefore, it cannot be found by eyes whether or not the positional shift of one glass mask plate relative to the other is caused.

Further, the exposing step is repeated about 700 times in one or two days to expose all of the iron plate 1 wound round the drums 8. When the iron plate 1 is once interposed between the glass mask plates 6 and 7, therefore, the positional shift cannot be confirmed by eyes on the way of the course of repeating the exposing step even if this positional shift of one glass mask plate relative to the other is caused. This may lead to a plenty of inferior products.

From JP 62-211657 there is known a printing method for printed circuit boards which comprises the steps of aligning upper and lower mask films provided on opposite sides of the printed circuit board with each other and with the printed circuit board. The mask films and the circuit board are each provided with four reference marks and the alignment process is carried out in three steps in that the masks are first brought into tight contact with each other without the circuit board being interposed. After the masks are adjusted in alignment with each other, the circuit board is inserted between the masks and one of the masks is moved such that the alignment mark formed thereon is brought into alignment with the respective identical alignment mark formed on the circuit board. The distances of this dislocation of the first mask during this alignment step are determined and subsequently the second mask is moved by the same distances in the third step. Finally, the masks and the circuit board are aligned altogether with respect to their alignment marks.

It is the object of the present invention to provide an exposing method and apparatus capable of detecting a positional shift of a mask plate relative to another mask plate between which an object, particularly a long iron plate to be exposed and having photosensitive material coated on both sides thereof, is interposed, and capable of simply, easily and quickly correcting the position of one mask plate relative to the other in accordance with the detected positional shift.

According to the present invention, there is provided an exposing method as defined in claim 1 and an exposing apparatus as defined in claim 6.

This invention can be more fully understood from the following detailed description when taken in conjunction with the accompanying drawings, in which:

Fig. 1 is a sectional view showing a part of the shadow mask for the color picture tube;
Fig. 2 is a sectional view showing an exposed plate between two mask plates;

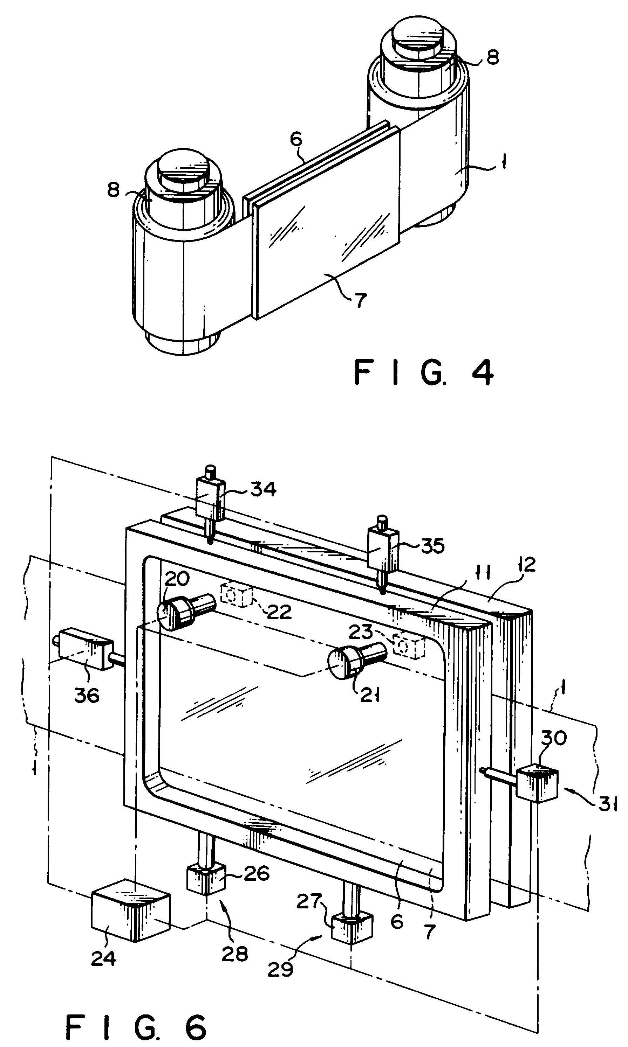

Figs. 3 and 4 are perspective views showing the conventional exposing apparatus;

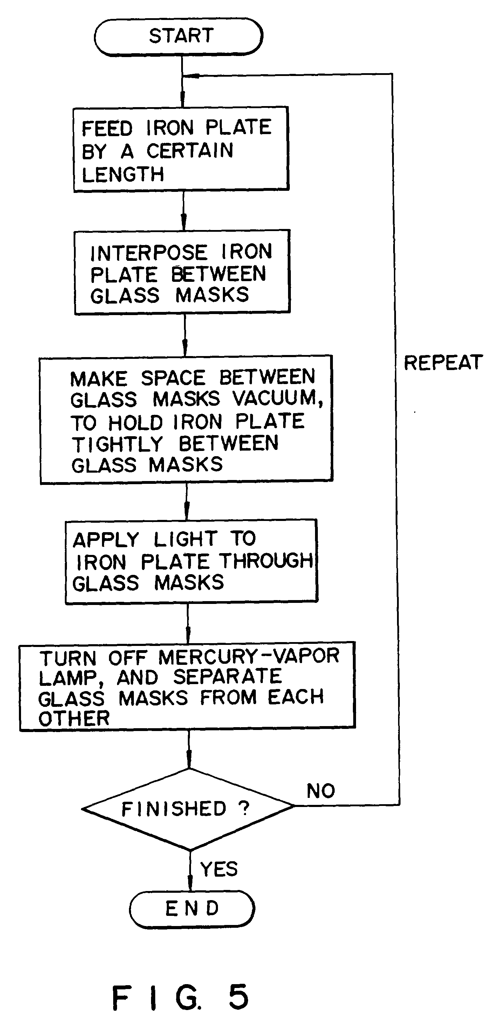

Fig. 5 is a flow chart showing the conventional exposing process;

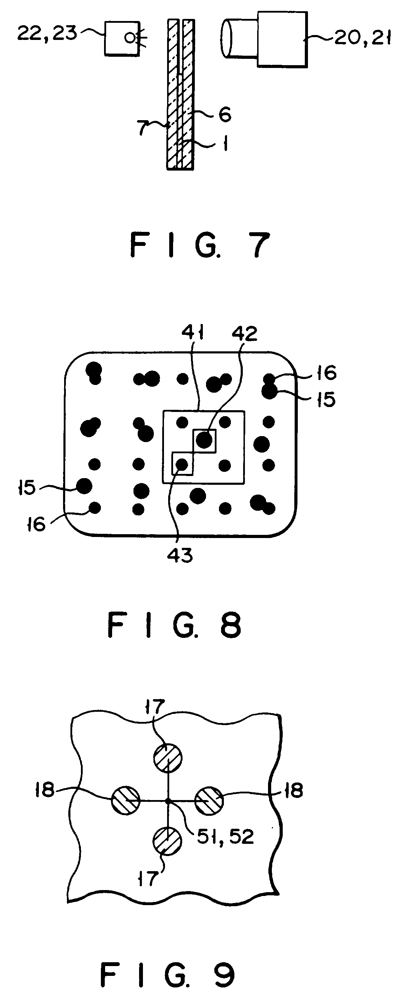

Fig. 6 is a perspective view showing an example of the exposing apparatus according to the present invention;
Fig. 7 shows a photographing means employed by the apparatus shown in Fig. 6;
Fig. 8 shows an example of an alignment pattern employed by the method of the present invention;
Fig. 9 shows another preferred example of an alignment pattern employed by the method of the present invention;

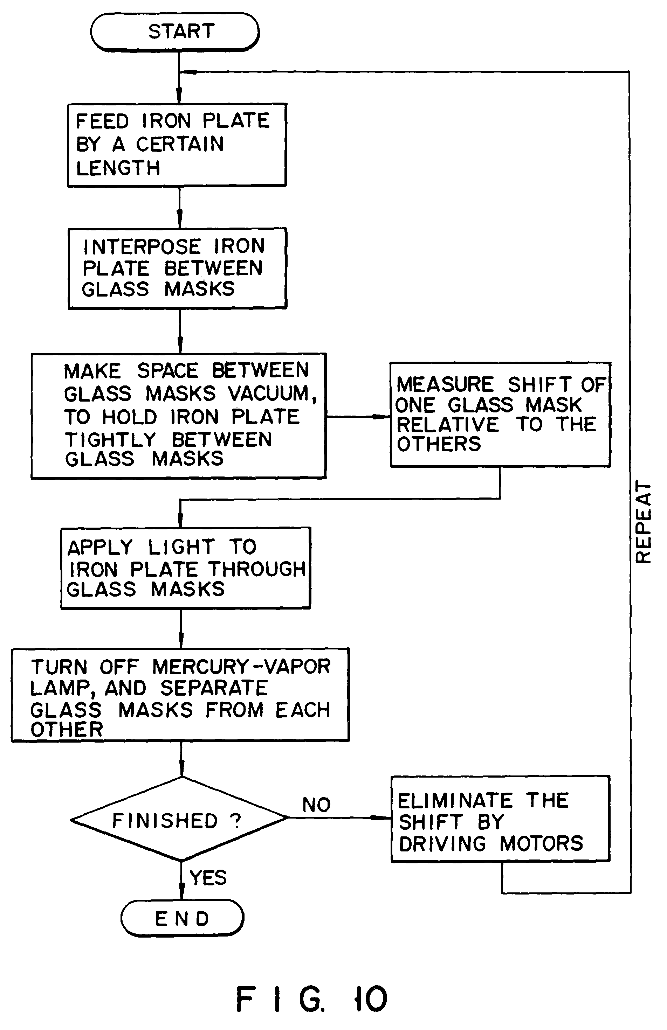

Fig. 10 is a flow chart showing the exposing process of the present invention;

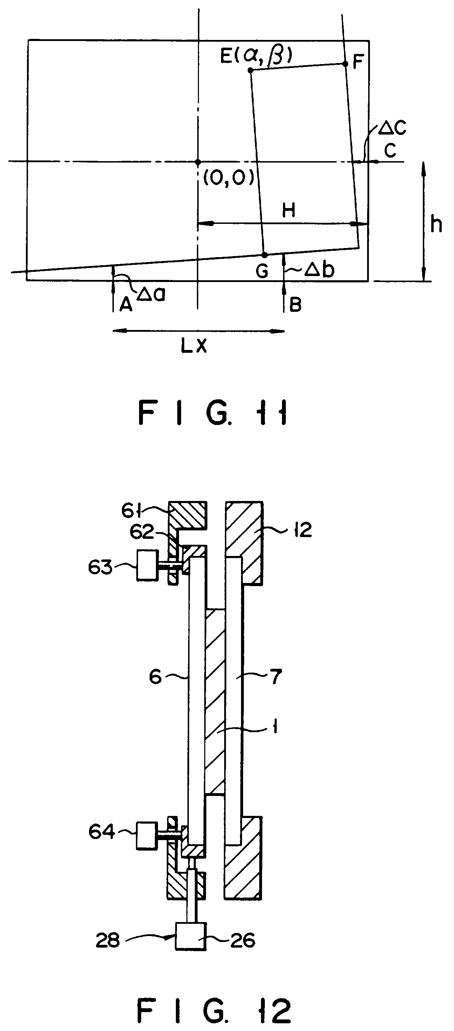

Fig. 11 is intended to explain a formula for correcting misregistration according to the method of the present invention; and

Fig. 12 is a sectional view showing a variation of the exposing apparatus according to the present invention.

Some embodiments of the present invention will be described in detail referring to the accompanying drawings.

Fig. 6 shows an example of the exposing apparatus according to the present invention. The exposing apparatus shown in Fig. 6 is used to make the shadow masks for the color picture tubes shown in Fig. 1. The shadow mask is an iron plate 1 provided with a plurality of apertures 2.

As shown in Fig. 2, the iron plate 1 having photosensitive material layers 3 coated on both surfaces thereof is closely held between a first glass mask plate 6 on the inner face of which a large aperture pattern 4 is drawn and a second glass mask plate 7 on the inner face of which a small aperture pattern 5 is drawn. Ultraviolet rays are irradiated from mercury-vapor lamps to both surfaces of the iron plate 1 to expose the photosensitive material layers 3 thereon and the photosensitive material layers 3 at those areas on both surfaces of the iron plate 1 where the photosensitive material layers 3 are not exposed are removed from both surfaces of the iron plate 1 to form etching resistive patterns thereon. Using the etching resistive patterns as masks, the iron plate 1 is etched by acid to form a plurality of apertures 2 which pass through the iron plate 1.

In Fig. 6, the first and second glass mask plates 6 and 7 are held in rectangular frames 11 and 12, respectively, and the long iron plate 1 moves between these glass mask plates 6 and 7. The rectangular frames 11 and 12 can be opened and closed in the opposed direction. In other words, they can be separated from each other and come close to each other. When they are closed, the glass mask plates 6 and 7 are contacted with both surfaces of the iron plate 1 to hold the iron plate 1 between them. When the space between the glass mask plates 6 and 7 is evacuated, the glass mask plates 6 and 7 can be closely contacted with the photosensitive material layers 3 on both surfaces of the iron plate 1.

Alignment patterns 15 and 16 shown in Fig. 8 or those 17 and 18 shown in Fig. 9 are drawn or bonded at those areas on the glass mask plates 6 and 7 which are not contacted with the iron plate 1 to oppose to each other. As shown in Fig. 7, CCD cameras 20 and 21 are arranged outside the glass mask plate 6 and illuminating light sources 22 and 23 are arranged outside the other glass mask plate 7, sandwiching the alignment patterns on both inner faces of the glass mask plates 6 and 7 between them. Image signal is applied from the CCD cameras 20 and 21 to an arithmetic unit 24.

Misregistration correcting mechanisms 28 and 29 which are driven by motors 26 and 27 are attached to the underside of the frame 11 in which the glass mask plate 6 is held, and a misregistration correcting mechanism 31 which is driven by a motor 30 is attached to one side of the frame 11. The frame 11 can be moved up and down and right and left by these misregistration correcting mechanisms 28, 29 and 31, which can be controlled by the arithmetic unit 24.

Correction amount measuring mechanisms 34 and 35 are attached to the top of the frame 11, opposing to the misregistration correcting mechanisms 28 and 29, and a correction amount measuring mechanism 36 is attached to the side of the frame 11, opposing to the misregistration correcting mechanism 31. The movement amount of the frame 11 practically moved by the misregistration correcting mechanisms 28, 29 and 31 can be measured by the correction amount measuring mechanisms 34, 35 and 36 which are opposed to the misregistration correcting mechanisms 28, 29 and 31. Results measured by these correction amount measuring mechanisms 34, 35 and 36 are applied to the arithmetic unit 24.

The alignment patterns 15 and 16 shown in Fig. 8 or the alignment patterns 17 and 18 shown in Fig. 9 on the inner faces of the glass mask plates 6 and 7 are image-sensed by the CCD cameras 20 and 21 and the alignment pattern 15 or 17 misregistered relative to the other alignment pattern 16 or 18 is detected and the amount of the misregistration is calculated as will be described later. The movement amount of the frame 11 which is to be practically moved is measured by the correction amount measuring mechanisms 34, 35 and 36 according to the calculated value. The frame 11 is thus moved up and down as well as right and left by the misregistration correcting mechanisms 28, 29 and 31 to correct the positional shift of the aperture pattern 4 on the inner face of the glass mask plate 6 relative to the aperture pattern 5 on the inner face of the glass mask plate 7.

A clearance equal to the width of the iron plate 1 is formed between the glass mask plates 6 and 7. In order to simultaneously image-sense the alignment patterns 15 and 16 or 17 and 18, it is needed that each of the CCD cameras 20 and 21 includes an optical system having a depth of field larger than 0.25 mm.

The manner of calculating the amount of misregistration by means of the arithmetic unit 24 will be described with the example of the alignment patterns of Fig.8.

The alignment patterns 15 and 16 comprise a plurality of black dots different in size and arranged at different pitches on the inner sides of the two glass mask plates 6 and 7. Namely, a plurality of black dots large in size are arranged at a large pitch on the inner side of the glass mask plate 6, while a plurality of black dots small in size are arranged at a small pitch on the inner side of the glass mask plate 7. When these alignment patterns 15 and 16 are used, it can be decided by the size of the black dots which of the two glass mask plates they belong to. In addition, a portion 41 where the large black dot is not overlapped by the small one and the distance between the large and the small dot is smaller than 1 mm necessarily exists between the alignment patterns 15 and 16. These make it easy to set the apparatus.

When it is assumed that the dimension of an image pickup element in each of the CCD cameras 20 and 21 is 6 x 8 mm, that optical magnification is set about 5 times, that a plurality of black dots each having a diameter of 100 μm are arranged at a pitch of 500 μm on the inner side of the glass mask plate 6, that a plurality of black dots each having a diameter of 60 μm are arranged at a pitch of 300 μm on the inner side of the glass mask plate 7, and that coordinates of the center on a line connecting centers of black dots 42 and 43 which are independent of the other and which are not overlapped each other are calculated on the base of $x = \Sigma x_n / \Sigma n$ and $y = \Sigma y_n / \Sigma n$, measurement can be achieved with an accuracy of about 1.4 μm. $x_n$ and $y_n$ represent coordinates in a case where a visual field image-sensed by the CCD cameras 20 and 21 is divided like a matrix and the image element of the matrix is black, n denotes 1 when the image element is similarly black, and $\Sigma n$ denotes the total of n relating to the black image elements.

When the alignment patterns 15 and 16 are used, it is determined how the aperture pattern 4 on the inner side of the glass mask plate 6 is overlapped by the aperture pattern 5 on the inner side of the glass mask plate 7, the misregistration of the aperture pattern 4 relative to the aperture pattern 5 is corrected by moving one of the glass mask plates 6 and 7, and the positional shift of the black dot 42 relative to the black dot 43 is thereafter observed on the basis of positions of the black dots at the portion 41 between the alignment patters 15 and 16 which have been measured till then.

One 17 of the alignment patterns 17 and 18 shown in Fig. 9 comprises a pair of black dots arranged in the vertical direction on the inner side of one glass mask plate 6 and the other 18 comprises a pair of black dots arranged in the horizontal direction on the inner side of the other glass mask plate 7.

In the case of the method using the alignment patterns 15 and 16 shown in Fig. 8, the aperture patterns 4, 5 and the alignment patterns 15, 16 cannot be set in a certain positional relation, but in the case of the preferred method of using the alignment patterns 17 and 18 shown in Fig. 9, the aperture patterns 4, 5 and the alignment patterns 17, 18 can be set in a positional relation. When the alignment patterns 17 and 18 on the inner sides of the glass mask plates 6 and 7 are set in the certain positional relation, they can be automatically aligned with each other.

More concretely, when the diameter of each of the black dots of the alignment patterns 17 and 18 is set 50 μm and distances between the paired upper and lower black dots and between the paired right and left black dots of the alignment patterns 17 and 18 on the inner sides of the glass mask plates 6 and 7 are set about 300 μm, centers on those lines which connect the paired upper and lower black dots and the paired right and left black dots can be measured with an accuracy of about 1 to 1.5 μm.

When centers 51 and 52 on those lines which connect the paired upper and lower black dots and between the paired right and left black dots of the alignment patterns 17 and 18 are overlapped each other as shown in Fig. 9, the aperture patterns 4 and 5 on the inner sides of the glass mask plates 6 and 7 can be positioned with high accuracy.

As described above, the positional misregistration of the alignment pattern 15 or 17 relative to the alignment pattern 16 or 18 can be both detected, the amount of the alignment pattern 15 or 16 misregistered can be calculated, and the positional misregistration of the aperture pattern 4 on the inner side of the glass mask plate 6 relative to the aperture pattern 5 on the inner side of the glass mask plate 7 can be automatically corrected on the basis of the amount of misregistration thus calculated by means of the apparatus shown in Fig. 6. Practically, the exposing operation is repeated as shown by a flow chart in Fig. 10.

The flow chart shown in Fig. 10 is different from the one shown in Fig. 5 in "misregistration measuring" and "misregistration correcting" steps. The reason why the "misregistration correcting" step is not carried out just after the "misregistration measuring" step in the flow chart shown in Fig. 10 is that when the "misregistration correcting" step is carried out at this point, the glass mask plates 6 and 7 rub against the iron plate 1 because they are closely contacted with the iron plate 1. When the positional misregistration is caused, therefore, the iron plate 1 is exposed from both sides thereof with the glass mask plates 6 and 7 positionally misregistered. Because the "misregistration measuring and correcting" steps are carried out every time the iron plate 1 is exposed, the positional misregistration of the glass mask plate 6 relative to the glass mask plate 7 does not become large and it can be therefore expected that the positional misregistration is in a range of allowable values.

The amount of the glass mask plate 6 positionally misregistered relative to the glass mask plate 7 usually reaches 10 to 15 μm because these plates 6 and 7 are thermally expanded by the irradiation of the mercury-vapor lamps, but according to the above-described method of the present invention, it can be kept smaller than 5 μm.

Fig. 11 shows an example of the misregistration correcting step.

When it is assumed that movement amounts of the frame 11 moved at points A, B and C by the misregistration correcting mechanisms 28, 29 and 31 are Δa, Δb and Δc and its positionally misregistered amounts viewed at a point E through the CCD camera 21 and viewed at another point E' (not shown) through the CCD camera 20 are (ex, ey) and (ex', ey'), the following equations can be obtained:

$$ey + ey' = (\Delta a + \Delta b)(h + \beta) \qquad (1)$$
$$ey - ey' = 2\alpha/Lx(\Delta a - \Delta b)(h - \beta) \qquad (2)$$
$$ex + ex' = 2H\{\beta/Lx(\Delta a-\Delta b) + \Delta c\} \qquad (3)$$
$$ex - ex' = -2\alpha\{\beta/Lx(\Delta a-\Delta b) + \Delta c\} \qquad (4)$$

Very small second-order terms are removed from these equations. It is assumed that the view points E and E' are positioned right and left and symmetrical to their center axis.

When the positional misregistration is measured in this manner, it may be corrected on the basis of the above-mentioned equations.

Although the positional misregistration is corrected after the exposing operation in the case of the above-described embodiment of the present invention, it may be arranged that the two glass mask plates are not shifted from each other again by fixing one of the glass mask plates which has been moved to correct the positional misregistration. This example of the exposing apparatus is shown in Fig. 12.

In the case of the exposing apparatus shown in Fig. 12, the frame 11 for holding one glass mask plate 6 comprises a fixed frame 61 and an adjustable frame 62 movably attached to the fixed frame 61. Lock mechanisms 63 and 64 for the adjustable frame 62 are attached to the upper and lower beams of the fixed frame 61 with the two located at the upper beam and the other two at the lower beam, and the adjustable frame 62 is held by the glass mask plate 6 and moved by the misregistration correcting mechanisms 28, 29 and 31.

While releasing the adjustable frame 62 freely movable from the lock mechanisms 63 and 64, the adjustable frame 62 is moved by the misregistration correcting mechanisms 28, 29 and 31 to correct the positional misregistration, and the lock mechanisms 63 and 64 are then made operative by a cylinder to fix the adjustable frame 62 relative to the fixed frame 61. This enables the positional accuracy of the glass mask plate 6 to be kept just after the misregistration correcting step.

According to the present invention as described above, the amount of one of the two glass mask plates positionally misregistered relative to the other can be detected with high accuracy and this positional misregistration can be easily corrected in accordance with the positionally misregistered amount of the plate detected even when the exposed plate which has photosensitive material coated on both sides thereof and which is to be exposed from both sides thereof is sandwiched between the two glass mask plates.

## Claims

1. A method of exposing a long iron plate (1) from both sides thereof, wherein said iron plate (1) having a photosensitive material (3) coated on both sides thereof is held between a first mask plate (6) provided with a first masking pattern (4) on the inner side thereof and a second mask plate (7) provided with a second masking pattern (5) on the inner side thereof, said method comprising the steps of:

    simultaneously image-sensing first and second alignment patterns (17, 18) formed at those areas on the inner sides of the first and second mask plates (6, 7) where the iron plate (1) is not held by the first and second mask plates (6, 7) so as to obtain an image signal, said first and second alignment patterns (17, 18) being in a predetermined positional relation when the first and second mask plates (6, 7) are correctly aligned with each other, said first alignment pattern (17) comprising a pair of marks arranged in the vertical direction and said second alignment pattern (18) comprising a pair of marks arranged in the horizontal direction;
    processing the image signal to determine the positionally misregistered amount of the first and second alignment patterns (17, 18) from the predetermined positional relation;
    exposing both sides of the iron plate (1) to photoradiation through the first and second mask plates (6, 7);
    moving one of the first and second mask plates (6, 7) in a direction along the iron plate (1) to correct the positionally misregistered amount of the alignment patterns (17, 18) determined by the processing of the image signal; moving the iron plate (1) by a certain length; and repeating the previous steps.

2. The exposing method according to claim 1, wherein said first and second alignment patterns (15, 16) comprise a plurality of circular marks, the circular marks of the first alignment pattern (15) are different in size and pitch from those of the second alignment pattern (16), and those circular marks of the first and second alignment patterns (15, 16) which are separated from each other by a predetermined distance are image-sensed.

3. The exposing method according to claim 1, wherein said marks of the first alignment pattern (17) arranged in the vertical direction and said marks of the second alignment pattern (18) arranged in the horizontal direction are circular.

4. The exposing method according to claim 1, wherein after the iron plate (1) is held between the first and the second mask plates (6, 7), the space between the first and the second mask plates (6, 7) is evacuated to closely contact the first and second mask plates (6, 7) with the iron plate (1), and the image-sensing step is then carried out.

5. The exposing method according to claim 1, wherein said one of the first and second mask plates (6, 7) is moved while keeping this moving mask plate separated from the iron plate (1).

6. An apparatus for exposing a long iron plate (1) from both sides thereof using the exposing method according to claim 1, wherein

said iron plate (1) having a photosensitive material (3) coated on both sides thereof is held between a first mask plate (6) provided with a first masking pattern (4) on the inner side thereof and a second mask plate (7) provided with a second masking pattern (5) on the inner side thereof, said apparatus comprising:

means (20, 21, 22, 23) for simultaneously image-sensing first and second alignment patterns (17, 18) formed at those areas on the inner sides of the first and second mask plates (6, 7) where the iron plate (1) is not held by the first and second mask plates (6, 7) so as to obtain an image signal, said first and second alignment patterns (17, 18) being in a predetermined positional relation when the first and second mask plates (6, 7) are correctly aligned with each other, said first alignment pattern (17) comprising a pair of marks arranged in the vertical direction and said second alignment pattern (18) comprising a pair of marks arranged in the horizontal direction;

means for processing the image signal to determine the positionally misregistered amount of the first and second alignment patterns (17, 18) from the predetermined positional relation;

means for exposing both sides of the iron plate (1) to photoradiation through the first and second mask plates (6, 7);

means for moving one of the first and second mask plates (6, 7) in a direction along the iron plate (1) to correct the positionally misregistered amount of the alignment pattern (17, 18) determined by the processing of the image signal;

means for moving the iron plate (1) by a certain length; and

means for repeating the previous steps.

7. The exposing apparatus according to claim 6, wherein said image-sensing means comprises two pairs of cameras (20, 21) and light sources (22, 23) arranged outside the first and second mask plates (6, 7) sandwiching the first and second alignment patterns (17, 18) between them.

8. The exposing apparatus according to claim 6 or 7, wherein said first and second mask plates (6, 7) are supported at the outer circumference by first and second frames (11, 12) and said correcting means comprises first misregistration correcting mechanisms (28, 29) driven by motors (26, 27) attached to the underside of the first frame (11) which supports the moving mask plate (6), and a second misregistration correcting mechanism (31) driven by a motor (30) attached to one side of the first frame (11).

9. The exposing apparatus according to claim 6, 7 or 8, further comprising first correction amount measuring mechanisms (34, 35) attached to the top of the first frame (11) and opposed to the first misregistration correcting mechanisms (28, 29) and a second correction amount measuring mechanism (36) attached to another side of the first frame (11) and opposed to the second misregistration correcting mechanism (31) to measure the respective amounts of horizontal and vertical movement of the first frame (11), respectively.

10. The exposing apparatus according to claim 9, wherein said first frame (11) comprises a fixed frame portion (61) and a movable frame portion (62), locking mechanisms (63, 64) are attached to the fixed frame portion (61) to lock the movable frame portion (62), and said movable frame portion (62) is movable by said misregistration correcting mechanisms (28, 29, 31).

**Patentansprüche**

1. Verfahren zum Belichten einer (eines) langen Eisenplatte bzw. -blechs (1) von ihren bzw. seinen beiden Seiten her, wobei das Eisenblech (1), das auf seinen beiden Seiten mit je einem lichtempfindlichen Material (3) beschichtet ist, zwischen einer ersten Maskenplatte (6), die an ihrer Innenseite mit einem ersten Maskierungsmuster (4) versehen ist, und einer zweiten Maskenplatte (7), die an ihrer Innenseite mit einem zweiten Maskierungsmuster (5) versehen ist, (fest)-gehalten oder verspannt wird, welches Verfahren folgende Schritte umfaßt:

gleichzeitiges bildmäßiges Abtasten bzw. Aufnehmen (image-sensing) von ersten und zweiten Ausrichtmustern (17, 18), die an den Bereichen der Innenseiten der ersten und zweiten Maskenplatten (6, 7) geformt sind, wo das Eisenblech (1) durch die ersten und zweiten Maskenplatten (6, 7) nicht (fest)gehalten wird, zwecks Gewinnung eines Bildsignals, wobei die ersten und zweiten Ausrichtmuster (17, 18) sich in einer vorbestimmten Lagenbeziehung befinden, wenn die ersten und zweiten Maskenplatten (6, 7) korrekt zueinander ausgerichtet sind, und wobei das erste Ausrichtmuster (17) zwei in der Vertikalrichtung angeordnete Marken und das zweite Ausrichtmuster (18) zwei in der Horizontalrichtung angeordnete Marken aufweisen, Verarbeiten des Bildsignals zwecks Bestimmung der Lagenfehldeckungsgröße der ersten und zweiten Ausrichtmuster (17, 18) anhand (from) der vorbestimmten Lagenbeziehung,

Belichten beider Seiten des Eisenblechs (1) mit Photostrahlung durch die ersten und zweiten Maskenplatten (6, 7),

Verschieben einer der ersten und zweiten Maskenplatten (6, 7) in einer Richtung längs des Eisenblechs (1) zum Korrigieren der durch Verarbeitung des Bildsignals bestimmten Lagenfehldeckungsgröße der Ausrichtmuster (17, 18),

Verschieben des Eisenblechs (1) um eine bestimmte Länge und

Wiederholen der vorstehenden Schritte.

2. Belichtungsverfahren nach Anspruch 1, wobei die ersten und zweiten Ausrichtmuster (15, 16) (jeweils) eine Vielzahl von kreisförmigen Marken umfassen, die kreisförmigen Marken des ersten Ausrichtmusters (15) in Größe und (Mitten-oder Teilungs-) Abstand von denen des zweiten Ausrichtmusters (16) verschieden sind und die kreisförmigen Marken der ersten und zweiten Ausrichtmuster (15, 16), die voneinander in einem vorbestimmten Abstand angeordnet sind, bildmäßig abgetastet bzw. aufgenommen (image-sensed) werden.

3. Belichtungsverfahren nach Anspruch 1, wobei die in der Vertikalrichtung angeordneten Marken des ersten Ausrichtmusters (17) und die in der Horizontalrichtung angeordneten Marken des zweiten Ausrichtmusters (18) kreisförmig sind.

4. Belichtungsverfahren nach Anspruch 1, wobei nach dem Festhalten des Eisenblechs (1) zwischen den ersten und zweiten Maskenplatten (6, 7) der Raum zwischen den ersten und zweiten Maskenplatten (6, 7) evakuiert wird, um die ersten und zweiten Maskenplatten (6, 7) in enge Berührung mit dem Eisenblech (1) zu bringen, worauf der Bildabtast- oder Aufnahmeschritt (image-sensing step) durchgeführt wird.

5. Belichtungsverfahren nach Anspruch 1, wobei eine der ersten und zweiten Maskenplatten (6, 7) verschoben wird, während diese sich verschiebende Maskenplatte vom Eisenblech (1) getrennt gehalten wird.

6. Vorrichtung zum Belichten einer (eines) langen Eisenplatte bzw. -blechs (1) von ihren bzw. seinen beiden Seiten her unter Anwendung des Belichtungsverfahrens nach Anspruch 1, wobei

das Eisenblech (1), das auf seinen beiden Seiten mit je einem lichtempfindlichen Material beschichtet ist, zwischen einer ersten Maskenplatte (6), die an ihrer Innenseite mit einem ersten Maskierungsmuster (4) versehen ist, und einer zweiten Maskenplatte (7), die an ihrer Innenseite mit einem zweiten Maskierungsmuster (5) versehen ist, (fest)gehalten oder verspannt wird, welche Vorrichtung umfaßt:

Mittel (20, 21, 22, 23) zum gleichzeitigen bildmäßigen Abtasten bzw. Aufnehmen (image-sensing) erster und zweiter Ausrichtmuster (17, 18), die in den Bereichen an den Innenseiten der ersten und zweiten Maskenplatten (6, 7) geformt sind, wo das Eisenblech (1) durch die ersten und zweiten Maskenplatten (6, 7) nicht (fest)gehalten ist, zwecks Gewinnung eines Bildsignals, wobei die ersten und zweiten Ausrichtmuser (17, 18) sich in einer vorbestimmten Lagenbeziehung befinden, wenn die ersten und zweiten Maskenplatten (6, 7) korrekt zueinander ausgerichtet sind, und wobei das erste Ausrichtmuster (17) zwei in der Vertikalrichtung angeordnete Marken und das zweite Ausrichtmuster (18) zwei in der Horizontalrichtung angeordnete Marken aufweisen,

Mittel zum Verarbeiten des Bildsignals zwecks Bestimmung der Lagenfehldeckungsgrößen der ersten und zweiten Ausrichtmuster (17, 18) anhand (from) der vorbestimmten Lagenbeziehung,

Mittel zum Belichten der beiden Seiten des Eisenblechs (1) mit Photostrahlung durch die ersten und zweiten Maskenplatten (6, 7),

Mittel zum Verschieben einer der ersten und zweiten Maskenplatten (6, 7) in einer Richtung längs des Eisenblechs (1) zum Korrigieren der durch Verarbeitung des Bildsignals bestimmten Lagenfehldeckungsgröße der Ausrichtmuster (17, 18).

Mittel zum Verschieben des Eisenblechs (1) um eine bestimmte Länge und

Mittel zum Wiederholen der vorhergehenden Schritte.

7. Belichtungsvorrichtung nach Anspruch 6, wobei die Mittel zum bildmäßigen Abtasten bzw. Aufnehmen zwei Paare von Kameras (20, 21) und Lichtquellen (22, 23) umfassen, welche außenseitig zu den ersten und zweiten Maskenplatten (6, 7), welche die ersten und zweiten Ausrichtmuster (17, 18) zwischen sich einschließen, angeordnet sind.

8. Belichtungsvorrichtung nach Anspruch 6 oder 7, wobei die ersten und zweiten Maskenplatten (6, 7) am Außenumfang durch erste und zweite Rahmen (11, 12) gehaltert sind und die Korrigiermittel erste Fehldeckungs-Korrigiermechanismen (28, 29), die durch an der Unterseite des die verschiebbare Maskenplatte (6) tragenden ersten Rahmens (11) angebrachte Motoren (26, 27) antreibbar sind, und einen zweiten Fehldeckungs-Korrigiermechanismus (31) umfassen, der durch einen an einer Seite des ersten Rahmens (11) angebrachten Motor (30) antreibbar ist.

9. Belichtungsvorrichtung nach Anspruch 6, 7 oder 8, ferner umfassend erste Korrekturgrößen-Meßmechanismen (34, 35), die an der Oberseite des ersten Rahmens (11) angebracht sind und den ersten Fehldeckungs-Korrigiermechanismen (28, 29) gegenüberstehen, und einen zweiten KorrekturgrößenMechanismus (36), der an der anderen Seite des ersten Rahmens (11) angebracht ist und dem zweiten Fehldeckungs-Korrigiermechanismus (31) gegenübersteht, zum Messen der jeweiligen Größen der Horizontal- bzw. Vertikalbewegung oder -verschiebung des ersten Rahmens (11).

10. Belichtungsvorrichtung nach Anspruch 9, wobei der erste Rahmen (11) einen feststehenden Rahmenabschnitt (61) und einen verschiebbaren Rahmenabschnitt (62) aufweist, am feststehenden Rahmenabschnitt (61) Arretiermechanismen (63, 64) zum Arretieren des verschiebbaren Rahmenabschnitts (62) angebracht sind und der verschiebbare Rahmenabschnitt (62) durch die Fehldeckungs-Korrigiermechanismen (28, 29, 31) verschiebbar ist.

## Revendications

1. Procédé pour exposer une longue plaque de fer (1) à partir des deux côtés de celle-ci, dans lequel ladite plaque de fer (1) ayant une matière photosensible étendue sur les deux côtés de celle-ci est maintenue entre une première plaque formant masque (6) munie d'un premier motif de masquage (4) sur le côté intérieur de celle-ci, et une deuxième plaque formant masque (7) munie d'un deuxième motif de masquage (5) sur le côté intérieur de celle-ci, ledit procédé comprenant les étapes consistant à:

   - détecter simultanément par image des premier et deuxième motifs d'alignement (17, 18) formés dans les zones des côtés intérieurs des première et deuxième plaques formant des masques (6, 7) où la plaque de fer (1) n'est pas maintenue par les première et deuxièmes plaques formant des masques (6, 7) de manière à obtenir un signal d'image, lesdits premier et deuxième motifs d'alignement (17, 18) étant dans une relation de position prédéterminée lorsque les première et deuxième plaques formant des masques (6, 7) sont correctement alignées l'une sur l'autre, ledit premier motif d'alignement (17) comprenant une paire de marques disposées dans la direction verticale et ledit deuxième motif d'alignement (18) comprenant une paire de marques disposées dans la direction horizontale;

   - traiter le signal d'image pour déterminer la valeur du défaut d'alignement de position des premier et deuxième motifs d'alignement (17, 18) d'après la relation de position prédéterminée;

   - exposer les deux côtés de la plaque de fer (1) à un rayonnement lumineux à travers les première et deuxième plaques formant des masques (6, 7);

   - déplacer une des première et deuxième plaques formant des masques (6, 7) dans une direction le long de la plaque de fer (1) pour corriger la valeur du défaut d'alignement de position des motifs d'alignement (17, 18) déterminée par le traitement du signal d'image;

   - déplacer la plaque de fer (1) d'une certaine longueur; et

   - répéter les étapes précédentes.

2. Procédé d'exposition selon la revendication 1, dans lequel lesdits premier et deuxième motifs d'alignement (15, 16) comprennent une pluralité de marques circulaires, les marques circulaires du premier motif d'alignement (15) sont différentes comme taille et comme pas de celles du deuxième motif d'alignement (16), et les marques circulaires des premier et deuxième motifs d'alignement (15, 16) qui sont séparées l'une de l'autre par une distance prédéterminée sont détectées par image.

3. Procédé d'exposition selon la revendication 1, dans lequel lesdites marques du premier motif d'alignement (17) disposées dans la direction verticale et lesdites marques du deuxième motif d'alignement (18) disposées dans la direction horizontale sont circulaires.

4. Procédé d'exposition selon la revendication 1, dans lequel, après que la plaque de fer (1) est maintenue entre les première et deuxième plaques formant des masques (6, 7), l'espace compris entre les première et deuxième plaques formant des masques (6, 7) est vidé d'air pour mettre étroitement en contact les première et deuxième plaques formant des masques (6, 7) avec la plaque de fer (1), et l'étape de détection d'image est ensuite exécutée.

5. Procédé d'exposition selon la revendication 1, dans lequel une desdites première et deuxième plaques formant des masques (6, 7) est déplacée tout en maintenant cette plaque formant masque séparée de la plaque de fer (1).

6. Dispositif pour exposer une longue plaque de fer (1) à partir des deux côtés de celle-ci en utilisant le procédé d'exposition selon la revendication 1, dans lequel:

- ladite plaque de fer (1) ayant une matière photosensible (3) étendue sur les deux côtés de celle-ci est maintenue entre une première plaque formant masque (6) munie d'un premier motif de masquage (4) sur le côté intérieur de celle-ci et une deuxième plaque formant masque (7) munie d'un deuxième motif de masquage (5) sur le côté intérieur de celle-ci, ledit dispositif comprenant:

- des moyens (20, 21, 22, 23) pour détecter simultanément par image des premier et deuxième motifs d'alignement (17, 18) formés dans les zones sur les côtés intérieurs des première et deuxième plaques formant des masques (6, 7) où la plaque de fer (1) n'est pas maintenue par les première et deuxième plaques formant des masques (6, 7), de manière à obtenir un signal d'image, lesdits premier et deuxième motifs d'alignement (17, 18) étant dans une relation de position prédéterminée lorsque les première et deuxième plaques formant des masques (6, 7) sont alignées correctement l'une sur l'autre, ledit premier motif d'alignement (17) comprenant une paire de marques disposées dans la direction verticale et ledit deuxième motif d'alignement (18) comprenant une paire de marques disposées dans la direction horizontale;

- des moyens pour traiter le signal d'image pour déterminer la valeur du défaut d'alignement de position des premier et deuxième motifs d'alignement (17, 18) par rapport à la relation de position prédéterminée;

- des moyens pour exposer les deux côtés de la plaque de fer (1) à un rayonnement lumineux à travers les première et deuxième plaques formant des masques (6, 7);

- des moyens pour déplacer une des première et deuxième plaques formant des masques (6, 7) dans une direction le long de la plaque de fer (1) pour corriger la valeur du défaut d'alignement de position des motifs d'alignement (17, 18) déterminée par le traitement du signal d'image;

- des moyens pour déplacer la plaque de fer (1) d'une certaine longueur; et

- des moyens pour répéter les étapes précédentes.

7. Dispositif d'exposition selon la revendication 6, dans lequel lesdits moyens de détection d'image comprennent deux paires d'appareils de prise de vues (20, 21) et de sources de lumière (22, 23) disposées à l'extérieur des première et deuxième plaques formant des masques (6, 7) prenant en sandwich les premier et deuxième motifs d'alignement (17, 18) entre elles.

8. Dispositif d'exposition selon la revendication 6 ou 7, dans lequel lesdites première et deuxième plaques formant des masques (6, 7) sont supportées au niveau de leur périphérie extérieure par des premier et deuxième cadres (11, 12) et lesdits moyens de correction comprennent des premiers mécanismes de correction de défaut d'alignement (28, 29) entraînés par des moteurs (26, 27) fixés au côté inférieur du premier cadre (11) qui supporte la plaque formant masque en mouvement (6), et un deuxième mécanisme de correction de défaut d'alignement (31) entraîné par un moteur (30) fixé à un côté du premier cadre (11).

9. Dispositif d'exposition selon la revendication 6, 7 ou 8, comprenant en outre des premiers mécanismes de mesure de valeur de correction (34, 35) fixés au haut du premier cadre (11) et opposés aux premiers mécanismes de correction de défaut d'alignement (28, 29), et un deuxième mécanisme de mesure de valeur de correction (36) fixé à un autre côté du premier cadre (11) et opposé au deuxième mécanisme de correction de défaut d'alignement (31) pour mesurer les valeurs respectives du mouvement horizontal et vertical du premier cadre (11), respectivement.

10. Dispositif d'exposition selon la revendication 9; dans lequel ledit premier cadre (11) comprend une partie de cadre fixe (61) et une partie de cadre mobile (62), des mécanismes de verrouillage (63, 64) sont fixés à la partie de cadre fixe (61) pour verrouiller la partie de cadre mobile (62), et ladite partie de cadre mobile (62) est déplaçable par lesdits mécanismes de correction de défaut d'alignement (28, 29, 31).

F I G. 1

F I G. 2

F I G. 3

F I G. 4

F I G. 6

```
                    ┌─────────────┐
                    │    START    │
                    └─────────────┘
                           │
      ┌────────────────────┼───────────────────────┐
      │                    ▼                        │
      │          ┌───────────────────┐             │
      │          │ FEED IRON PLATE   │             │
      │          │ BY A CERTAIN      │             │
      │          │ LENGTH            │             │
      │          └───────────────────┘             │
      │                    │                        │
      │          ┌───────────────────┐             │
      │          │ INTERPOSE IRON    │             │
      │          │ PLATE BETWEEN     │             │
      │          │ GLASS MASKS       │             │
      │          └───────────────────┘             │
      │                    │                   REPEAT
      │     ┌──────────────────────────┐        │
      │     │ MAKE SPACE BETWEEN       │        │
      │     │ GLASS MASKS VACUUM,      │        │
      │     │ TO HOLD IRON PLATE       │        │
      │     │ TIGHTLY BETWEEN          │        │
      │     │ GLASS MASKS              │        │
      │     └──────────────────────────┘        │
      │                    │                     │
      │          ┌───────────────────┐          │
      │          │ APPLY LIGHT TO    │          │
      │          │ IRON PLATE THROUGH│          │
      │          │ GLASS MASKS       │          │
      │          └───────────────────┘          │
      │                    │                     │
      │     ┌──────────────────────────┐        │
      │     │ TURN OFF MERCURY-VAPOR   │        │
      │     │ LAMP, AND SEPARATE       │        │
      │     │ GLASS MASKS FROM EACH    │        │
      │     │ OTHER                    │        │
      │     └──────────────────────────┘        │
      │                    │                     │
      │                    ▼           NO        │
      │            ◇ FINISHED ? ◇ ─────────────┘
      │                    │
                        YES │
                    ┌─────────────┐
                    │    END      │
                    └─────────────┘
```

# F I G. 5

22,23 ⟋ ⊙⊏

6

7 ⟋

1

# F I G. 7

41    42

16

15

15 ⟋

16 ⟋

43

# F I G. 8

17

18 ⟋    ⟋ 18

51, 52

17

# F I G. 9

```
                    ┌─────────────┐
                    (   START     )
                    └──────┬──────┘
                           │                                              ┌───────────────┐
                    ┌──────▼──────┐                                       │               │
                    │ FEED IRON PLATE │                                   │               │
                    │ BY A CERTAIN    │                                   │               │
                    │ LENGTH          │                                   │               │
                    └──────┬──────┘                                       │               │
                           │                                              │               │
                    ┌──────▼──────┐                                       │               │
                    │ INTERPOSE IRON  │                                   │               │
                    │ PLATE BETWEEN   │                                   │               │
                    │ GLASS MASKS     │                                   │               │
                    └──────┬──────┘                                       │               │
                           │                                              │               │
          ┌────────────────▼──────────┐    ┌──────────────────┐          │               │
          │ MAKE SPACE BETWEEN         │    │ MEASURE SHIFT OF │          │               │
          │ GLASS MASKS VACUUM,        │───▶│ ONE GLASS MASK   │          │               │
          │ TO HOLD IRON PLATE         │    │ RELATIVE TO THE  │          │ REPEAT        │
          │ TIGHTLY BETWEEN            │    │ OTHERS           │          │               │
          │ GLASS MASKS                │    └─────────┬────────┘          │               │
          └───────────┬───────────────┘              │                   │               │
                      └──────────────┐    ┌───────────┘                   │               │
                    ┌────────────────▼────┐                               │               │
                    │ APPLY LIGHT TO      │                               │               │
                    │ IRON PLATE THROUGH  │                               │               │
                    │ GLASS MASKS         │                               │               │
                    └──────┬──────────────┘                               │               │
                           │                                              │               │
                    ┌──────▼──────────────┐                               │               │
                    │ TURN OFF MERCURY-VAPOR │                            │               │
                    │ LAMP, AND SEPARATE     │                            │               │
                    │ GLASS MASKS FROM EACH  │                            │               │
                    │ OTHER                  │                            │               │
                    └──────┬─────────────┘                                │               │
                           │                                              │               │
                        ◇──▼──◇           NO      ┌──────────────────┐    │               │
                      ◇ FINISHED? ◇───────────────▶│ ELIMINATE THE   │    │               │
                        ◇─────◇                    │ SHIFT BY        │────┘               │
                           │ YES                   │ DRIVING MOTORS  │
                    ┌──────▼──────┐                └──────────────────┘
                    (   END       )
                    └─────────────┘
```

# F I G. 10

F I G. 11

F I G. 12